# EUROPEAN PATENT APPLICATION

(11) **EP 4 676 187 A2**
(43) Date of publication of application: **07.01.2026**
(21) Application number: 25161544.9
(22) Date of filing: 04.03.2025
(51) Int. Cl.: H10D 84/01, H10D 84/03, H10D 84/83, H10D 30/60, H10D 64/27

(54) **SEMICONDUCTOR DEVICES**

(30) Priority: 05.07.2024 KR 20240088718
(71) Applicant: Samsung Electronics Co., Ltd., Suwon-si, Gyeonggi-do 16677 (KR)
(72) Inventor: KIM, Donggun, 16677 Suwon-si, Gyeonggi-do (KR); KIM, Minkyung, 16677 Suwon-si, Gyeonggi-do (KR); LEE, Eunyoung, 16677 Suwon-si, Gyeonggi-do (KR); LEE, Hayoung, 16677 Suwon-si, Gyeonggi-do (KR)
(74) Representative: Kuhnen & Wacker Patent- und Rechtsanwaltsbüro PartG mbB

(57) **Abstract**

The semiconductor device includes a first transistor and a second transistor. The first transistor includes a first gate structure including a first gate interface pattern, a first gate dielectric pattern, a second gate dielectric pattern and a first gate electrode structure sequentially stacked on a first region of a substrate including the first region and a second region, wherein the second gate dielectric pattern contains an oxide of a second metal or an oxynitride of the second metal. The second transistor includes a second gate structure including a second gate interface pattern, a third gate dielectric pattern, a fourth gate dielectric pattern and a second gate electrode sequentially stacked on the second region of the substrate, wherein the fourth gate dielectric pattern contains an oxide of a third metal or an oxynitride of the third metal.

## Description

### CROSS-REFERENCE TO RELATED APPLICATION

This application claims priority under 35 U.S.C. § 119 to Korean Patent Application No. 10-2024-0088718 filed on July 5, 2024 in the Korean Intellectual Property Office, the disclosure of which is hereby incorporated by reference in its entirety.

### TECHNICAL FIELD

Example embodiments relate to a semiconductor device.

### DISCUSSION OF RELATED ART

In a semiconductor device, a gate structure may include a gate interface pattern and a gate electrode. Effective work function (eWF) is a value derived from flat band voltage (V_{fb}) which is measured through Cyclic Voltammetry (C-V) of the gate interface pattern and the gate electrode. An effective work function of the gate electrode is distinguished from an intrinsic work function of the gate electrode in that the effective work function of the gate electrode may be influenced by a material comprising the gate interface pattern, interface characteristics of the gate interface pattern and the gate electrode, etc. The effective work function of the gate electrode may be adjusted so that the gate structure may have an appropriate threshold voltage (Vₜₕ) value.

In a PMOS transistor, a work function difference between a first gate electrode of the PMOS transistor and an n-type semiconductor substrate may be negative (Φₘ-Φₛ < 0), and in the NMOS transistor, a work function difference between a second gate electrode of the NMOS transistor and a p-type semiconductor substrate may be positive (Φₘ-Φₛ > 0). Accordingly, it may be advantageous to reduce an effective work function value of the second gate electrode of the NMOS transistor and to increase an effective work function value of the first gate electrode in the PMOS transistor to obtain an appropriate threshold voltage of each of the NMOS and PMOS transistors.

### SUMMARY

Example embodiments provide a semiconductor device having improved characteristics.

According to example embodiments, there is provided a semiconductor device. The semiconductor device may include a first transistor and a second transistor. The first transistor may include a first gate structure including a first gate interface pattern, a first gate dielectric pattern, a second gate dielectric pattern and a first gate electrode structure sequentially stacked on a first region of a substrate including the first region and a second region, wherein the first gate dielectric pattern contains a compound of a first metal, wherein a dielectric constant of the compound of the first metal is greater than a dielectric constant of silicon oxide, and wherein the second gate dielectric pattern contains an oxide of a second metal or an oxynitride of the second metal, the second metal being different from the first metal; and a first source/drain region at an upper portion of the substrate that is adjacent to the first gate structure and containing n-type impurities. The second transistor may include a second gate structure including a second gate interface pattern, a third gate dielectric pattern, a fourth gate dielectric pattern and a second gate electrode sequentially stacked on the second region of the substrate, wherein the third gate dielectric pattern includes the compound of the first metal, wherein the fourth gate dielectric pattern contains an oxide of a third metal or an oxynitride of the third metal, the third metal being different from the first metal; and a second source/drain region at a second upper portion of the substrate that is adjacent to the second gate structure and containing p-type impurities. An oxygen areal density of the oxide of the second metal is smaller than an oxygen areal density of silicon oxide, and an oxide areal density of the oxide of the third metal is greater than the oxygen areal density of silicon oxide.

According to example embodiments, there is provided a semiconductor device. The semiconductor device may include a first transistor and a second transistor. The first transistor may include a first gate structure including a first gate interface pattern, a first gate dielectric pattern, a second gate dielectric pattern and a first gate electrode structure sequentially stacked on a first region of a substrate including the first region and a second region, wherein the second gate dielectric pattern contains an oxide of a first metal or an oxynitride of the first metal; and a first source/drain region at an upper portion of the substrate that is adjacent to the first gate structure. The second transistor may include a second gate structure including a second gate interface pattern, a third gate dielectric pattern, a fourth gate dielectric pattern and a second gate electrode sequentially stacked on the second region of the substrate, wherein the fourth gate dielectric pattern contains an oxide of a second metal or an oxynitride of the second metal, the second metal being different from the first metal; and a second source/drain region at a second upper portion of the substrate that is adjacent to the second gate structure. A positive charge is formed at a portion of the first gate interface pattern adjacent to a first interface of the first gate interface pattern and the first gate dielectric pattern, and a negative charge is formed at a portion of the first gate dielectric pattern adjacent to the first interface, thereby forming a dipole at a vicinity of the first interface, and a second negative charge is formed at a portion of the second gate interface pattern adjacent to a second interface of the second gate interface pattern and the third gate dielectric pattern, and a second positive charge is formed at a portion of the third gate dielectric pattern adjacent to the second interface, thereby forming a second dipole at a vicinity of the second interface.

According to example embodiments, there is provided a semiconductor device. The semiconductor device may include a first transistor, an epitaxial layer and a second transistor. The first transistor may include a first gate structure including a first gate interface pattern, a first gate dielectric pattern and a first gate electrode structure sequentially stacked on a NMOS region of a substrate including the NMOS region and a PMOS region, wherein the first gate dielectric pattern contains an oxide of a first metal or an oxynitride of the first metal, and wherein the first gate structure has a first gate electrode and a second gate electrode sequentially stacked; and a first source/drain region at an upper portion of the substrate adjacent to the first gate structure. The epitaxial layer may be disposed on the PMOS region of the substrate. The second transistor may include a second gate structure including a second gate interface pattern, a second gate dielectric pattern and a third gate electrode sequentially stacked on the epitaxial layer, wherein the second gate dielectric pattern contains an oxide of a second metal or an oxynitride of the second metal, the second metal being different from the first metal; and a second source/drain region at an upper portion of the epitaxial layer adjacent to the second gate structure. An interface oxide layer is disposed between the first gate electrode and the second gate electrode.

In a semiconductor device according to example embodiments, a first gate structure of an NMOS transistor may include a first gate dielectric pattern containing an oxide of a first metal or an oxynitride of the first metal, and a second gate structure of a PMOS transistor may include a second gate dielectric pattern containing an oxide of a second metal or an oxynitride of the second metal, the second metal being different from the first metal. Accordingly, an effective work function of the first gate electrode of the NMOS transistor may decrease and an effective work function of the second gate electrode of the PMOS transistor may increase, and threshold voltage of each of the NMOS transistor and the PMOS transistor may be adjusted independently.

### BRIEF DESCRIPTION OF THE DRAWINGS

FIGS. 1 and 2 are cross-sectional views illustrating a semiconductor device in accordance with example embodiments.
FIGS. 3 to 12 are cross-sectional views illustrating a method of manufacturing a semiconductor device according to example embodiments.
FIG. 13 is a cross-sectional view illustrating a semiconductor device in accordance with example embodiments.
FIG. 14 is a cross-sectional view illustrating a method of manufacturing semiconductor device in accordance with example embodiments.
FIG. 15 is a cross-sectional view illustrating a semiconductor device in accordance with example embodiments.
FIG. 16 is a cross-sectional view illustrating a method of manufacturing semiconductor device in accordance with example embodiments.

### DETAILED DESCRIPTION

The above and other aspects and features of the semiconductor devices and the methods of manufacturing the same in accordance with example embodiments will become readily understood from the detailed descriptions that follow, with reference to the accompanying drawings. It will be understood that, although the terms "first," "second," and/or "third" may be used herein to describe various materials, layers, regions, pads, electrodes, patterns, structures and/or processes, these various materials, layers, regions, pads, electrodes, patterns, structures and/or processes should not be limited by these terms. These terms are only used to distinguish one material, layer, region, pad, electrode, pattern, structure or process from another material, layer, region, pad, electrode, pattern, structure or process. Thus, "first", "second" and/or "third" may be used selectively or interchangeably for each material, layer, region, electrode, pad, pattern, structure or process respectively.

Terms such as "same," "equal," "planar," or "coplanar," as used herein when referring to orientation, layout, location, shapes, sizes, compositions, amounts, or other measures do not necessarily mean an exactly identical orientation, layout, location, shape, size, composition, amount, or other measure, but are intended to encompass nearly identical orientation, layout, location, shapes, sizes, compositions, amounts, or other measures within typical variations that may occur resulting from conventional manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

Throughout the specification, when a component is described as "including" or "containing" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

The term "substrate" may denote a base substrate (e.g., an initial semiconductor substrate forming the base of the wafer in the final wafer product, such as a bulk semiconductor substrate (e.g., formed of crystalline silicon), an silicon on insulator (SOI) substrate, etc.), or a stack structure including such a base substrate and layers formed on the substrate.

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures.

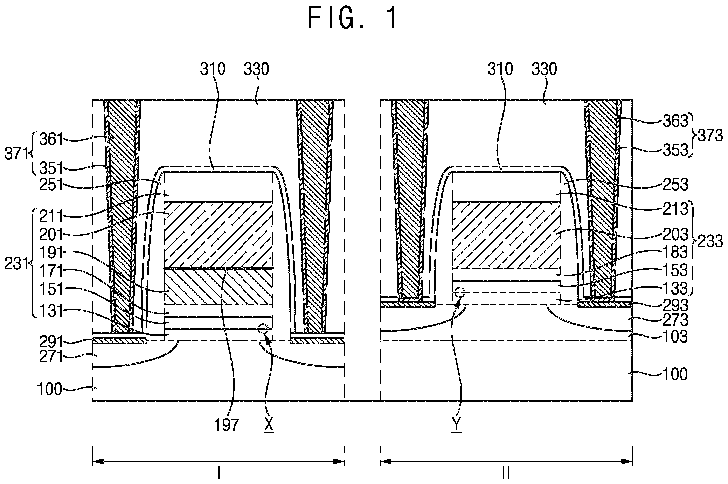

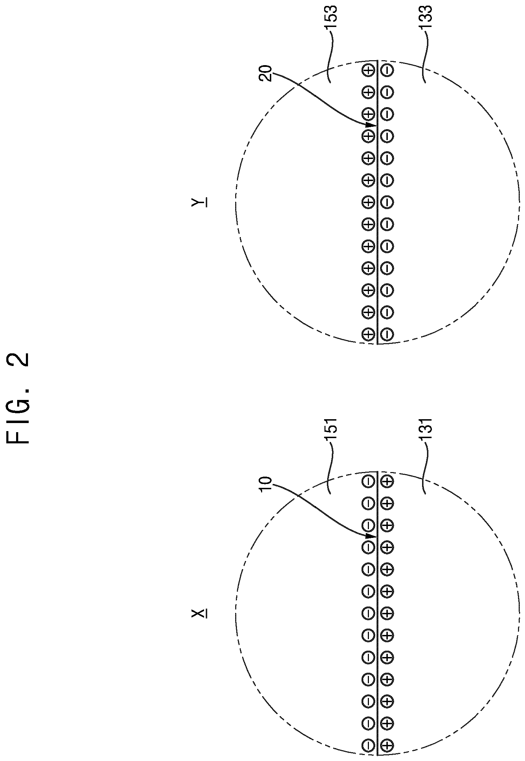

FIGS. 1 and 2 are cross-sectional views illustrating a semiconductor device (e.g., an integrated circuit formed as a semiconductor chip) in accordance with example embodiments, and FIG. 2 includes enlarged cross-sectional views of region X and region Y of FIG. 1. In some examples, the semiconductor device may be a complementary MOS (CMOS) device.

Referring to FIGS. 1 and 2, the semiconductor device may include a first transistor disposed on a first region I of the substrate 100 and a second transistor disposed on a second region II of the substrate 100.

The semiconductor device may also include an epitaxial layer 103, a first gate spacer 251, a second gate spacer 253, a first ohmic contact pattern 291, a second ohmic contact pattern 293, an etch stop layer 310, an insulating interlayer 330, a first contact plug 371 and a second contact plug 373.

The substrate 100 may include a first region I and a second region II. The first and second regions I and II of the substrate 100 may be adjacent to each other or may be spaced apart from each other. In example embodiments, the first region I may be an NMOS region where NMOS transistors are located, and the second region II may be a PMOS region where PMOS transistors are located. For example, the NMOS transistors of the first region I and the PMOS transistors of the second region II may together form a CMOS device.

An isolation pattern, insulating the first region I of the substrate 100 and the second region II of the substrate 100 from each other, may be disposed on an upper portion of the substrate 100. The isolation pattern may include, for example, silicon oxide.

The substrate 100 may include a semiconductor material, for example, silicon, silicon germanium, etc. A first well region doped with, for example, p-type impurities may be disposed at the first region I of the substrate 100, and a second well region doped with, for example, n-type impurities may be disposed at the second region II of the substrate 100.

In example embodiments, in reference to a lower surface of the substrate 100, a height of an upper surface of the first region I of the substrate 100 may be substantially the same as a height of an upper surface in the second region II of the substrate 100.

The epitaxial layer 103 may be disposed on the second region II of the substrate 100. The epitaxial layer 103 may include a semiconductor material, for example, germanium, silicon-germanium, etc. The epitaxial layer 103 may be doped with n-type impurities, and may form the second well region together with the second region II of the substrate 100.

In example embodiments, in reference to the lower surface of the substrate 100, a height of an upper surface of the epitaxial layer 103 may be greater than the height of the upper surface in the first region I of the substrate 100.

The first transistor may be disposed on the first region I of the substrate 100. The first transistor may include a first gate structure 231 and a first source/drain region 271.

The second transistor may be disposed on the second region II of the substrate 100. The second transistor may include a second gate structure 233 and a second source/drain region 273.

The first gate structure 231 may include a first gate interface pattern 131, a first gate dielectric pattern 151, a third gate dielectric pattern 171, a first gate electrode 191, a second gate electrode 201 and a first capping pattern 211 sequentially stacked on the first region I of the substrate 100. The first and second gate electrode 191 and 201 may together form a first gate electrode structure. An interface oxide layer 197 may be disposed at an interface of the first and second gate electrodes 191 and 201. For example, the first and second gate electrodes 191 and 201 may be separated from each other by the interface oxide layer 197 (e.g., may not be in contact with each other).

The second gate structure 233 may include a second gate interface pattern 133, a second gate dielectric pattern 153, a fourth gate dielectric pattern 183, a third gate electrode 203 and a second capping pattern 213 sequentially stacked on the epitaxial layer 103 on the second region II of the substrate 100.

In example embodiments, in reference to the lower surface of the substrate 100, a height of a lower surface of the second gate structure 233 may be greater than a height of a lower surface of the first gate structure 231.

The first and second gate interface patterns 131 and 133 may include, and/or may be formed only of, the same material, for example, an oxide such as silicon oxide. For example, the first and second gate interface patterns 131 and 133 may be patterned from the same layer. The first gate interface pattern 131 may be disposed between the substrate 100 and the first gate dielectric pattern 151, and the second gate interface pattern 133 may be disposed between the substrate 100 and the second gate dielectric pattern 153. Accordingly, interface characteristics between the substrate 100 and each of the first and second gate dielectric patterns 151 and 153 may be improved, and hence, mobility of carriers may be improved.

The first and second gate dielectric patterns 151 and 153 may include, for example, a high dielectric material (e.g., high dielectric constant material or high k material). A high dielectric material may refer to a material having a dielectric constant k greater than that of silicon oxide (approximately 3.9), which is generally used as a gate interface pattern.

Each of the first and second gate dielectric patterns 151 and 153 may include a compound of a first metal, for example, an oxide of the first metal, a silicate of the first metal, a silicate nitride of the first metal, etc.

The first metal may include hafnium (Hf), zirconium (Zr), or a combination thereof. The oxide of the first metal may include hafnium oxide, zirconium oxide, etc. The silicate of the first metal may include hafnium silicate (HfSiₓO_{y}), zirconium silicate (ZrSiₓO_{y}), etc. The silicate nitride of the first metal may include hafnium silicate nitride (HfSiₓO_{y}N_{z}), zirconium silicate nitride (ZrSiₓO_{y}N_{z}), etc.

The first gate dielectric pattern 151 may further include, for example, an oxide of a second metal which is different from the first metal. The second gate dielectric pattern 153 may further include, for example, an oxide of a third metal which is different from the first metal. The second gate dielectric pattern 153 may not include the oxide of the second metal.

The third gate dielectric pattern 171 may include, for example, the oxide of the second metal, an oxynitride of the second metal, etc. The second metal may include, for example, lanthanum (La), scandium (Sc), or a combination thereof. The oxide of the second metal may include lanthanum oxide, scandium oxide, etc. The oxynitride of the second metal may include lanthanum oxynitride, scandium oxynitride, etc.

The fourth gate dielectric pattern 183 may include, for example, the oxide of the third metal, an oxynitride of the third metal, etc. The third metal may include, for example, aluminum (Al), zirconium (Zr), titanium (Ti), or a combination thereof. The oxide of the third metal may include aluminum oxide, zirconium oxide, titanium oxide, etc. The oxynitride of the third metal may include aluminum oxynitride, zirconium oxynitride, titanium oxynitride, etc.

In example embodiments, an oxygen areal density of the oxide of the second metal may be smaller than an oxygen areal density of silicon oxide, and an oxygen areal density of the oxide of the third metal may be greater than an oxygen areal density of silicon oxide.

The second metal may diffuse from the third gate dielectric pattern 171 to the first gate dielectric pattern 151. Accordingly, the first gate dielectric pattern 151 may further include the oxide of the second metal which has a relatively low oxygen area density.

Negatively charged oxygen may diffuse from the first gate interface pattern 131 that may contain silicon oxide with a relatively high oxygen area density to the first gate dielectric pattern 151 that may contain the oxide of the second metal with a relatively low oxygen area density. Accordingly, a negative charge may be formed at a portion of the first gate dielectric pattern 151 adjacent to a first interface 10 of the first gate interface pattern 131 and the first gate dielectric pattern 151, and a positive charge may be formed at a portion of the first gate interface pattern 131 adjacent to the first interface 10.

As a result, a dipole may be induced at a vicinity of the first interface 10 of the first gate interface pattern 131 and the first gate dielectric pattern 151, and accordingly, the third gate dielectric pattern 171 may serve as a dipole inducing layer. As a dipole is induced at the vicinity of the first interface 10, the effective work function of the first gate electrode structure may decrease (as compared to the absence of this dipole inducing layer), and accordingly, the first transistor may have an appropriate threshold voltage.

Similarly, the third metal may diffuse from the fourth gate dielectric pattern 183 to the second gate dielectric pattern 153. Accordingly, the second gate dielectric pattern 153 may further include the oxide of the third metal which has a relatively high oxygen area density.

Negatively charged oxygen may diffuse from the second gate dielectric pattern 153 that may contain the oxide of the third metal with a relatively high oxygen area density to the second gate interface pattern 133 that may contain silicon oxide with a relatively low oxygen area density. Accordingly, a positive charge may be formed at a portion of the second gate dielectric pattern 153 adjacent to a second interface 20 of the second gate interface pattern 133 and the second gate dielectric pattern 153, and a negative charge may be formed at a portion of the second gate interface pattern 133 adjacent to the second interface 20.

As a result, a dipole may be induced at a vicinity of the second interface 20 of the second gate interface pattern 133 and the second gate dielectric pattern 153, and accordingly, the fourth gate dielectric pattern 183 may serve as a dipole inducing layer. As a dipole is induced at the vicinity of the second interface 20, the effective work function of the third gate electrode 203 may increase (as compared to the absence of this dipole inducing layer), and accordingly, the second transistor may have an appropriate threshold voltage.

In example embodiments, a thickness of the first gate electrode structure in the vertical direction may be greater than a thickness of the third gate electrode 203 in the vertical direction. In example embodiments, a thickness of the second gate electrode 201 in the vertical direction may be substantially the same as the thickness of the third gate electrode 203 in the vertical direction. For example, because the threshold voltages of the first and second transistors may be appropriately adjusted by adjusting the effective work function values of the respective gate electrode as disclosed herein, the thickness of the third gate electrode 203 may not need to be increased in order to compensate for a reduced effective work function.

The first gate electrode 191 may include, for example, a metal such as tungsten (W), a metal nitride such as titanium nitride (TiNₓ), etc. The second and third gate electrodes 201 and 203 may include, and/or may be formed only of, the same material to each other. For example, the second and third gate electrodes 201 and 203 may be patterned from the same layer. Each of the second and third gate electrodes 201 and 203 may include, for example, a metal such as tungsten (W), or a nitride of a fourth metal. The fourth metal may include titanium, aluminum, or a combination thereof.

The first and second capping patterns 211 and 213 may include and/or may be the same material, for example, an insulating nitride such as silicon nitride.

The first and second gate spacers 251 and 253 may cover sidewalls of the first and second gate structures 231 and 233, respectively. The first and second gate spacers 251 and 253 may include and/or may be the same material, for example, an oxide such as silicon oxide.

The first source/drain region 271 may be disposed at an upper portion of the first region I of the substrate 100 adjacent to the first gate structure 231. The first source/drain region 271 may include, for example, n-type impurities.

The second source/drain region 273 may be disposed at an upper portion of the epitaxial layer 103 adjacent to the second gate structure 233 on the second region II of the substrate 100. The second source/drain region 273 may include, for example, p-type impurities.

In the drawing, a lower surface of the second source/drain region 273 may be farther from the lower surface of the substrate 100 than a lower surface of the epitaxial layer 103, but the disclosed embodiments are not limited thereto. For example, the lower surface of the second source/drain region 273 may be closer to the lower surface of the substrate 100 than the lower surface of the epitaxial layer 103.

The first and second ohmic contact patterns 291 and 293 may be disposed on the first and second source/drain regions 271 and 273, respectively. Each of the first and second ohmic contact patterns 291 and 293 may include a metal silicide, for example, titanium silicide, cobalt silicide, nickel silicide, etc.

The etch stop layer 310 may be disposed on the first and second gate structures 231 and 233, the first and second gate spacers 251 and 253 and the first and second ohmic contact patterns 291 and 293. The insulating interlayer 330 may be formed on the etch stop layer 310. The etch stop layer 310 may include a nitride, for example, silicon nitride. The insulating interlayer 330 may include an oxide, for example, silicon oxide.

The first contact plug 371 may extend through the insulating interlayer 330 and the etch stop layer 310 on the first region I of the substrate 100 to contact an upper surface of the first ohmic contact pattern 291. The first contact plug 371 may include a first conductive pattern 361 and a first barrier pattern 351 covering a sidewall and a lower surface thereof.

The second contact plug 373 may extend through the insulating interlayer 330 and the etch stop layer 310 on the second region II of the substrate 100 to contact an upper surface of the second ohmic contact pattern 293. The second contact plug 373 may include a second conductive pattern 363 and a second barrier pattern 353 covering a sidewall and a lower surface thereof.

Each of the first and second conductive patterns 361 and 363 may include a metal, for example, tungsten. Each of the first and second barrier patterns 351 and 353 may include a metal nitride, for example, titanium nitride.

As described above, the first gate structure 231 of the first transistor may include the third gate dielectric pattern 171, and the second gate structure 233 of the second transistor may include the fourth gate dielectric pattern 183. Accordingly, a dipole may be induced at the first interface 10 by the third gate dielectric pattern 171 and the effective work function value of the first gate electrode structure may be reduced. Likewise, a dipole may be induced at the second interface 20 by the fourth gate dielectric pattern 183 and the effective work function value of the third gate electrode 203 may increase. Hence, each of the first and second transistors may include an appropriate dipole induction layer according to its own respective electrical characteristics, and the threshold voltage of each of the first and second transistors may be independently adjusted.

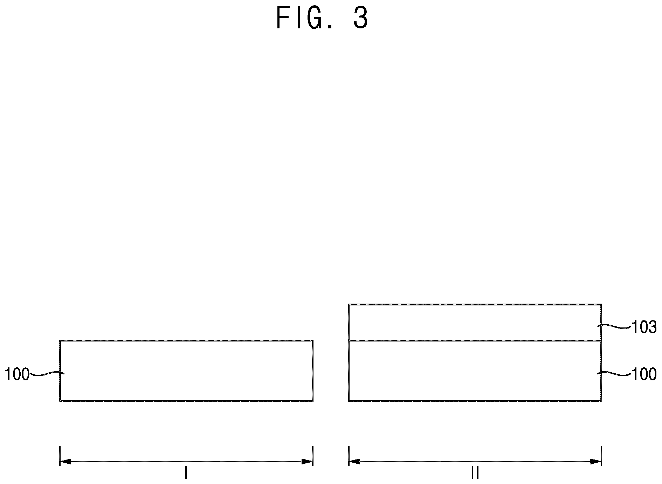

FIGS. 3 to 12 are cross-sectional views illustrating a method of manufacturing a semiconductor device according to example embodiments.

Referring to FIG. 3, after forming a first mask that may cover an upper surface of a first region I of a substrate 100 while exposing an upper surface of a second region II of the substrate 100, an epitaxial growth process may be performed on the exposed upper surface of the second region II of the substrate 100 to form the epitaxial layer 103.

In example embodiments, the substrate 100 may include a semiconductor material, for example, germanium, silicon-germanium, etc., and the substrate 100 may be a p-type semiconductor substrate including a first well region doped with p-type impurities.

The epitaxial layer 103 may include a semiconductor material, for example, germanium, silicon-germanium, etc. In example embodiments, an upper surface of the epitaxial layer 103 may be formed to be higher than the upper surface of the first region I of the substrate 100.

Thereafter, an ion implantation process may be performed on the second region II of the substrate 100 and the epitaxial layer 103 using n-type impurities. Thus, a second well region including a semiconductor material doped with n-type impurities may be formed on the second region II of the substrate 100 and the epitaxial layer 103.

The first mask can then be removed.

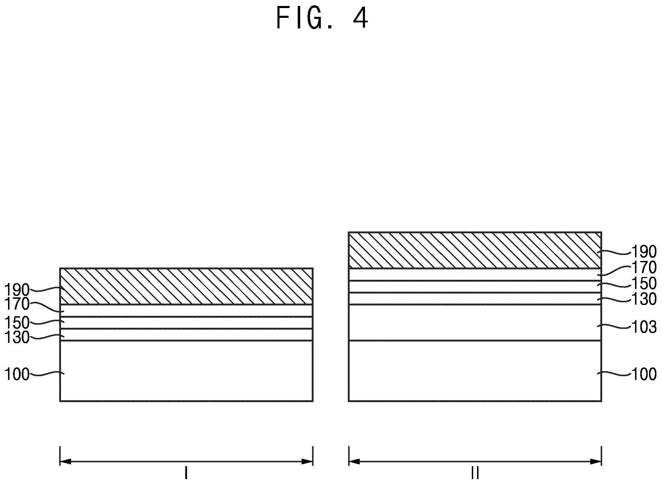

Referring to FIG. 4, a gate interface layer 130, a first gate dielectric layer 150, a second gate dielectric layer 170 and a first gate electrode layer 190 may be sequentially formed on the substrate 100 and the epitaxial layer 103.

The gate interface layer 130 may include an oxide, for example, silicon oxide.

The first gate dielectric layer 150 may include a high dielectric material having a dielectric constant greater than a dielectric constant of silicon oxide (approximately 3.9). Specifically, the first gate dielectric layer 150 may include, for example, an oxide of the first metal, a silicate of the first metal, or a silicate nitride of the first metal. The first metal may include, for example, hafnium (Hf), zirconium (Zr), etc. The oxide of the first metal may include, for example, hafnium oxide, zirconium oxide, etc. The silicate of the first metal may include, for example, hafnium silicate (HfSiₓO_{y}), zirconium silicate (ZrSiₓO_{y}), etc. The silicate nitride of the first metal may include, for example, hafnium silicate nitride (HfSiₓO_{y}N_{z}), zirconium silicate nitride (ZrSiₓO_{y}N_{z}), etc.

The second gate dielectric layer 170 may include, for example, an oxide of the second metal or an oxynitride of the second metal. The second metal may include, for example, lanthanum (La), scandium (Sc), etc.

The first gate electrode layer 190 may include a metal, for example, tungsten (W) or a metal nitride, for example, titanium nitride (TiNₓ).

In example embodiments, each of the gate interface layer 130, the first gate dielectric layer 150, the second gate dielectric layer 170 and the first gate electrode layer 190 may be formed by, for example, a Chemical Vapor Deposition (CVD) process, a Low-Pressure CVD (LPCVD) process, a Plasma-Enhanced CVD (PECVD) process, a Metal-Organic CVD (MOCVD) process, an Atomic Layer Deposition (ALD), a Plasma Enhanced ALD (PEALD) process, etc.

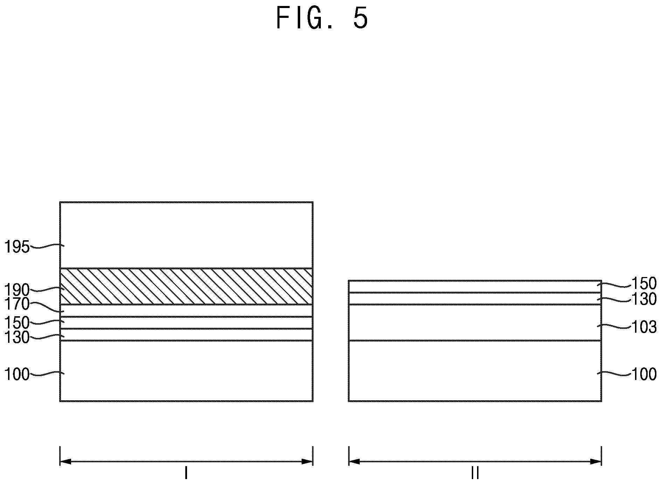

Referring to FIG. 5, after forming the second mask 195 covering a first portion of the first gate electrode layer 190 on the first region I of the substrate 100 while exposing a second portion of the first gate electrode layer 190 on the second region II of the substrate 100, the exposed second portion of the first gate electrode layer 190 and a portion of the second gate dielectric layer 170 on the second region II of the substrate 100 may be removed.

Accordingly, the second gate dielectric layer 170 and the first gate electrode layer 190 may remain only on the first region I of the substrate 100, and an upper surface of a portion of the first gate dielectric layer 150 on the second region II of the substrate 100 may be exposed.

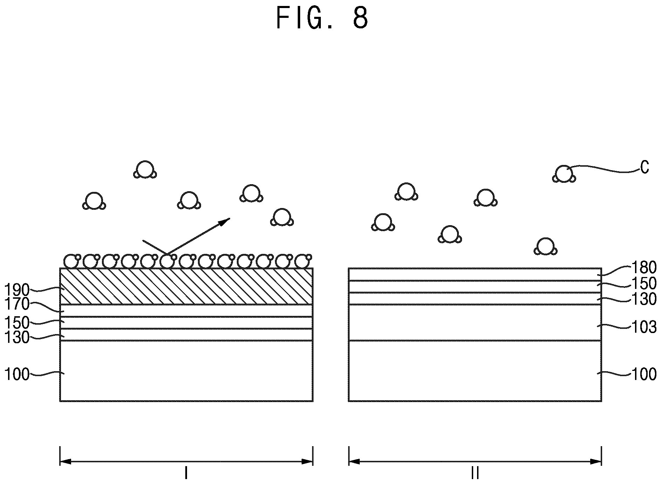

Hereinafter, a method of forming a third gate dielectric layer 180 (refer to FIG. 8) by performing an Area-Selective Atomic Layer Deposition (AS-ALD) process will be described.

The AS-ALD process may include a first step of injecting an inhibitor A into a reactor chamber, a second step of injecting a precursor B of a third metal into the reactor chamber, a third step of injecting a reactant C into the reactor chamber, and a fourth step of plasma processing. A cycle including the second and third steps may be repeated as needed, and a thickness of the third gate dielectric layer 180 may be adjusted by controlling the number of cycles, based on the thickness added per cycle.

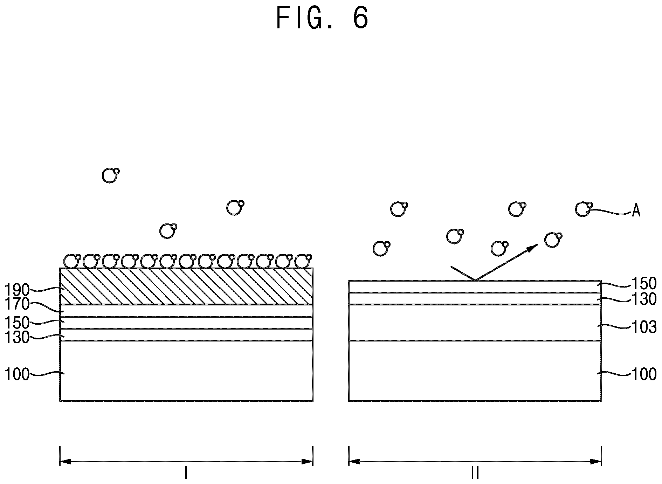

Referring to FIG. 6, after removing the second mask 195 to expose an upper surface of the first gate electrode layer 190 remaining on the first region I of the substrate 100, the first step of injecting the inhibitor A within the reactor chamber may be performed.

The inhibitor A may be selectively adsorbed on the upper surface of the first gate electrode layer 190 remaining on the first region I of the substrate 100.

The inhibitor A may include, for example, self-assembled monolayers (SAM), small molecule inhibitor (SMI), etc. The SMI may include aromatic compounds, for example aniline.

A purge process may be performed to remove any remaining inhibitor A not adsorbed onto the first gate electrode layer 190.

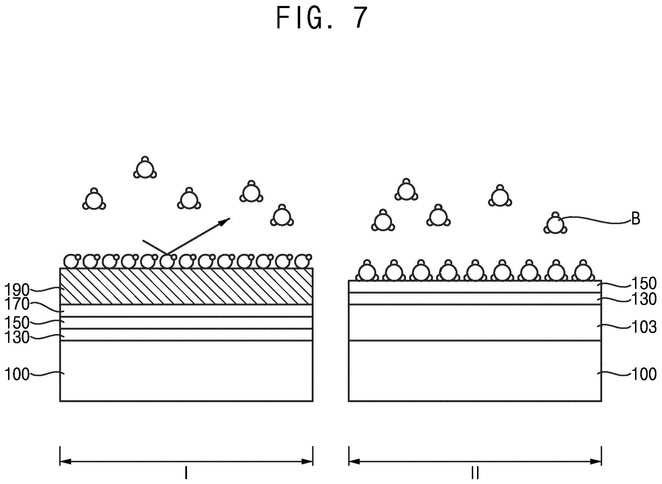

Referring to FIG. 7, the second step of injecting the precursor B of the third metal into the reactor chamber may be performed.

Since the inhibitor A may be adsorbed on the upper surface of the first gate electrode layer 190, the precursor B of the third metal may be adsorbed only on the upper surface of the first gate dielectric layer 150 on the second region II of the substrate 100.

The precursor B of the third metal may include, for example, trimethylaluminum (TMA), dimethylaluminum - isopropoxide (DMAI), tris(dimethylamido)aluminum(III) (TDMAA), [3-(dimethylamino)propyl]dimethylaluminum(III) (DMAD), zirconium chloride, zirconium alkoxide, β-diketonates, tetrakis-(dimethylamido)zirconium, tetrakis(methylethylamido) zirconium, tetrakis(diethylamido)-zirconium, tetrakis(dimethylamino)titanium (TDMAT), tetrakis(diethylamino)titanium (TDEAT), etc.

A purge process may be performed to remove any remaining precursor B of the third metal not adsorbed onto the first gate dielectric layer 150.

Referring to FIG. 8, the third step of injecting the reactant C into the reactor chamber may be performed.

Oxygen contained in the reactant C may react with the precursor B of the third metal adsorbed on the first gate dielectric layer 150 to form an oxide of the third metal. The reactant C may include an oxygen source, for example, water (H₂O), ozone (O₃), etc.

The third gate dielectric layer 180 including the oxide of the third metal may be formed by repeatedly performing the cycle including the second and third steps illustrated with reference to FIGS. 7 and 8.

In example embodiments, the reactant C may further include a nitrogen source, for example, ammonia (NH₃), pyridine (C₅H₅N), etc., and in this case, the third gate dielectric layer 180 may be formed to contain an oxynitride of the third metal.

A purge process may be performed to remove any remaining reactant C that did not react with the precursor B of the third metal.

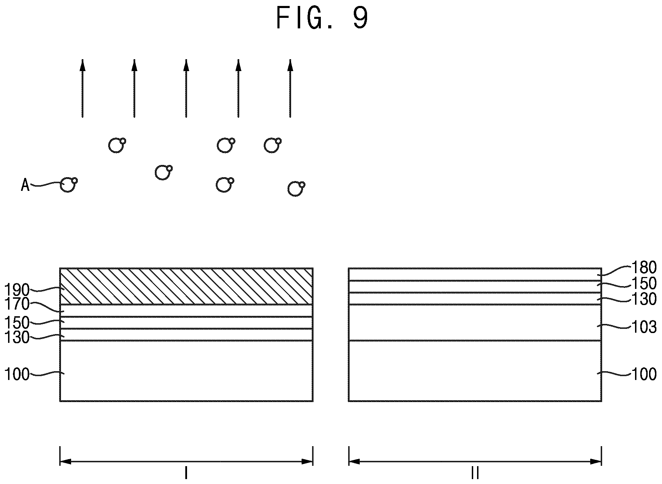

Referring to FIG. 9, plasma may be injected into the reactor chamber.

The plasma may include Ar-H₂ plasma. Accordingly, the inhibitor A adsorbed on the upper surface of the first gate electrode layer 190 may be removed, and the upper surface of the first gate electrode layer 190 on the first region I of the substrate 100 may be exposed again.

Alternatively, the third gate dielectric layer 180 may be formed on both of the first and second regions I and II of the substrate 100, and a portion of the third gate dielectric layer 180 on the first region I of the substrate 100 may be removed by an etching process which may use a third mask covering a portion of the third gate dielectric layer 180 formed on the second region II of the substrate 100 while exposing the portion of the third gate dielectric layer 180 on the first region I of the substrate 100.

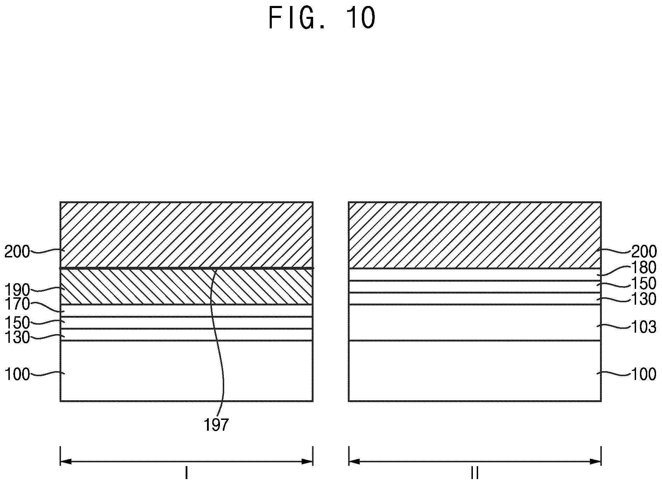

Referring to FIG. 10, a second gate electrode layer 200 may be formed on the first gate electrode layer 190 and the third gate dielectric layer 180.

The second gate electrode layer 200 may include a metal such as tungsten (W) or a nitride of a fourth metal. The fourth metal may include titanium, aluminum, or a combination thereof.

The second gate electrode layer 200 may be formed by, for example, a Chemical Vapor Deposition (CVD) process, a Low-Pressure CVD (LPCVD) process, a Plasma-Enhanced CVD (PECVD) process, a Metal-Organic CVD (MOCVD) process, an Atomic Layer Deposition (ALD), a Plasma Enhanced ALD (PEALD) process, etc.

In example embodiments, an interface oxide layer 197 may be formed at the interface of the first gate electrode layer 190 and the second gate electrode layer 200 due to a process delay.

Hereinafter, the gate interface layer 130, the first gate dielectric layer 150, the second gate dielectric layer 170, the first gate electrode layer 190 and the second gate electrode layer 200 on the first region I of the substrate 100 will be referred to as a first gate layer structure, and the gate interface layer 130, the first gate dielectric layer 150, the third gate dielectric layer 180 and the second gate electrode layer 200 on the second region II of the substrate 100 will be referred to as a second gate layer structure.

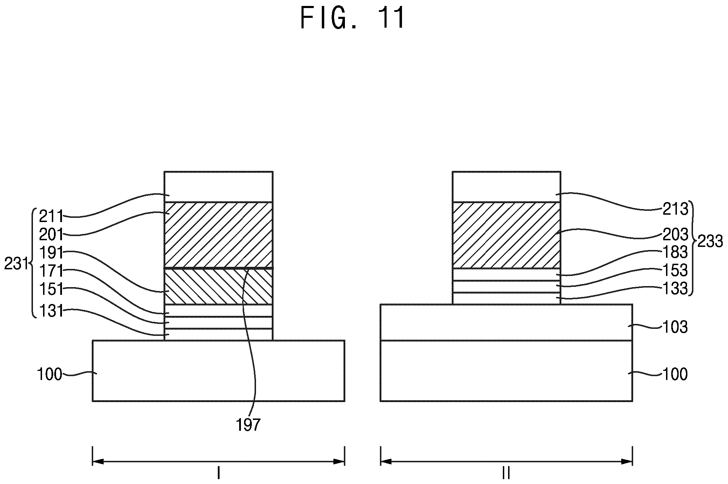

Referring to FIG. 11, after forming first and second capping patterns 211 and 213 on the first and second gate layer structures, respectively, an etching process using the first and second capping patterns 211 and 213 as an etch mask may be performed to pattern the first and second gate layer structures.

Accordingly, the portions of the gate interface layer 130, the first gate dielectric layer 150, the second gate dielectric layer 170, the first gate electrode layer 190 and the second gate electrode layer 200 located on the first region I of the substrate 100 may be respectively transformed to a first gate interface pattern 131, a first gate dielectric pattern 151, a third gate dielectric pattern 171, the first gate electrode 191 and the second gate electrode 201. The first and second gate electrodes 191 and 201 may together form a first gate electrode structure.

The portions of the gate interface layer 130, the first gate dielectric layer 150, the third gate dielectric layer 180 and the second gate electrode layer 200 located on the epitaxial layer 103 on the second region II of the substrate 100 may be respectively transformed to a second gate interface pattern 133, a second gate dielectric pattern 153, a fourth gate dielectric pattern 183 and a third gate electrode 203.

In example embodiments, a thickness of the second and third gate electrodes 201 and 203 in the vertical direction may be substantially the same to each other. As described herein, because the threshold voltages of the first and second transistors may be appropriately adjusted as disclosed herein, the thickness of the third gate electrode 203 may not need to be increased in order to compensate for a reduced effective work function.

The first gate interface pattern 131, the first gate dielectric pattern 151, the third gate dielectric pattern 171, the first gate electrode structure and the first capping pattern 211 sequentially stacked on the first region I of the substrate 100 may together form a first gate structure 231. The second gate interface pattern 133, the second gate dielectric pattern 153, the fourth gate dielectric pattern 183, the third gate electrode 203 and the second capping pattern 213 sequentially stacked on the epitaxial layer 103 of the second region II of the substrate 100 may together form the second gate structure 233.

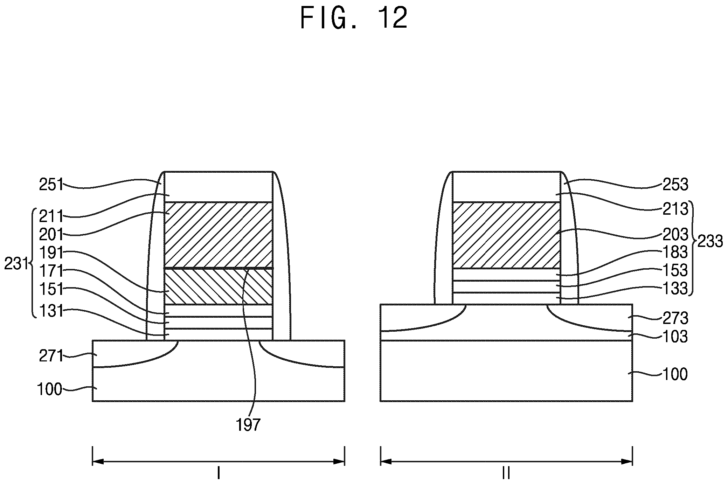

Referring to FIG. 12, a gate spacer layer may be, for example, conformally formed on the upper surface of the substrate 100, the upper surface of the epitaxial layer 103, a sidewall and an upper surface of the first gate structure 231 and a sidewall and an upper surface of the second gate structure 233, and an anisotropic etching process may be performed on the gate spacer layer to form first and second gate spacers 251 and 253 covering the sidewalls of the first and second gate structures 231 and 233, respectively.

An ion implantation process may be performed on an upper portion of the first region I of the substrate 100 adjacent to the first gate structure 231 to form a first source/drain region 271, and an ion implantation process may be performed on an upper portion of the epitaxial layer 103 adjacent to the second gate structure 233 to form a second source/drain region 273. In example embodiments, the first source/drain region 271 may be formed to include n-type impurities, and the second source/drain region 273 may be formed to include p-type impurities.

The first gate structure 231 and the first source/drain region 271 may together form a first transistor, and the second gate structure 233 and the second source/drain region 273 may together form a second transistor.

Referring to FIG. 1 again, first and second ohmic contact patterns 291 and 293 may be respectively formed on upper surfaces of the first and second source/drain regions 271 and 273.

In example embodiments, the first and second ohmic contact patterns 291 and 293 may be formed by forming a first metal layer on the first and second gate structures 231 and 233, the first and second gate spacers 251 and 253 and the first and second source/drain regions 271 and 273, performing a heat-treating process on the first metal layer, and removing an unreacted portion of the first metal layer. The first metal layer may include a metal, for example, titanium, cobalt, nickel.

An etch stop layer 310 and insulating interlayer 330 may be sequentially formed on the first and second ohmic contact patterns 291 and 293, the first and second gate spacers 251 and 253 and the first and second gate structures 231 and 233.

A first opening may be formed to extend through the insulating interlayer 330 and the etch stop layer 310 to expose an upper surface of the first ohmic contact pattern 291 on the first region I of the substrate 100, and a first contact plug 371 may be formed within the first opening. A second opening may be formed to extend through the insulating interlayer 330 and the etch stop layer 310 to expose an upper surface of the second ohmic contact pattern 293 on the second region II of the substrate 100, and a second contact plug 373 may be formed within the second opening.

In example embodiments, the first contact plug 371 may be formed to include a first conductive pattern 361 and a first barrier pattern 351 covering a sidewall and a lower surface thereof, and the second contact plug 373 may be formed to include a second conductive pattern 363 and a second barrier pattern 353 covering a sidewall and a lower surface thereof.

Thereafter, manufacturing of the semiconductor device may be completed by forming contact plugs and wirings electrically connected to various structures on the substrate 100.

As described above in the example of FIG. 5, in the method of manufacturing the semiconductor device, the second portion of the second gate dielectric layer 170 on the second region II of the substrate 100 including the oxide of the second metal or the oxynitride of the second metal may be removed.

However, in some cases, for example in some semiconductor devices, the second portion of the second gate dielectric layer 170 on the second region II of the substrate 100 may not be removed. In such cases, the second gate structure 233 may then be formed to further include a fifth gate dielectric pattern containing the oxide of the second metal or the oxynitride of the second metal, and to compensate for the decrease of effective work function of the third gate electrode 203 due to the fifth gate dielectric pattern, a fourth gate electrode may be additionally be required to be formed on the fifth gate dielectric pattern. In this case, level difference between the first and second gate structures 231 and 233 may increase, thereby increasing difficulty of manufacturing the semiconductor device.

However, in the disclosed example embodiments, since the second portion of the second gate dielectric layer 170 on the second region II of the substrate 100 is removed, there is no need to additionally form the fourth gate electrode, thereby alleviating the level difference between the first and second gate structures 231 and 233. Accordingly, the disclosed embodiments can reduce the difficulty of manufacturing the semiconductor device.

Additionally, as described above in the example of FIG. 8, in the method of manufacturing the semiconductor device, the AS-ALD process may be performed to selectively deposit the third gate dielectric layer 180 containing the oxide of the third metal or the oxynitride of the third metal on the second region II of the substrate 100.

In some cases, for example in some semiconductor devices, the thickness of the third gate electrode 203 in the vertical direction may be increased to increase the work function of the third gate electrode 203. However, as the thickness of the semiconductor device increases, leakage current may also increase, deteriorating electrical characteristics of the semiconductor device.

However, in the disclosed example embodiments, the second gate structure 233 may be formed to include the fourth gate dielectric pattern 183 derived from the third gate dielectric layer 180 selectively deposited on the second region II of the substrate 100 by, for example, the AS-ALD process. Accordingly, even without increasing the thickness of the third gate electrode 203, the threshold voltage of the second transistor may be appropriately adjusted by increasing the effective work function value of the third gate electrode 203, and thus, electrical characteristics of the semiconductor device may be improved without increasing leakage current.

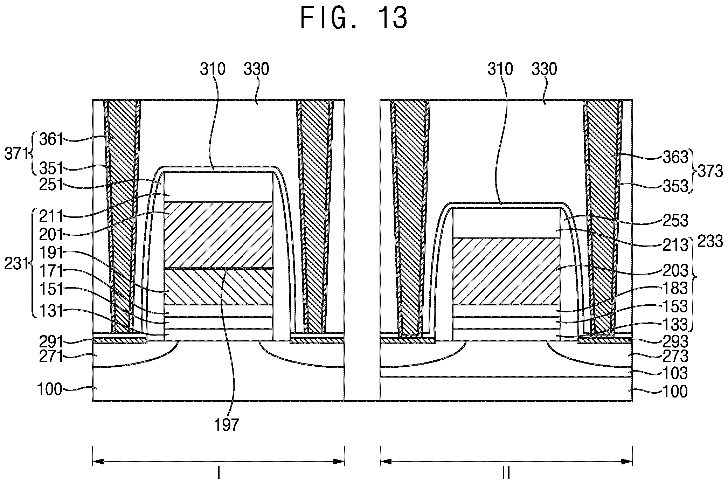

FIG. 13 is a cross-sectional view illustrating a semiconductor device in accordance with example embodiments. The semiconductor device may be the same as or similar to a semiconductor device of FIGS. 1 and 2, except for a height of the epitaxial layer 103, and thus repeated explanations are omitted herein.

Referring to FIG. 13, in reference to the lower surface of the substrate 100, the height of the upper surface in the second region II of the substrate 100 may be lower than the height of the upper surface in the first region I of the substrate 100.

In the drawing, in reference to the lower surface of the substrate 100, the height of the lower surface of the second gate structure 233 and the height of the lower surface of the first gate structure 231 are illustrated to be substantially the same, but the concept of the present invention is not limited thereto. For example, depending on a thickness in the vertical direction of the epitaxial layer 103, the height of the lower surface of the second gate structure 233 may be higher (as in the example of FIG. 1) or lower than the height of the lower surface of the first gate structure 231.

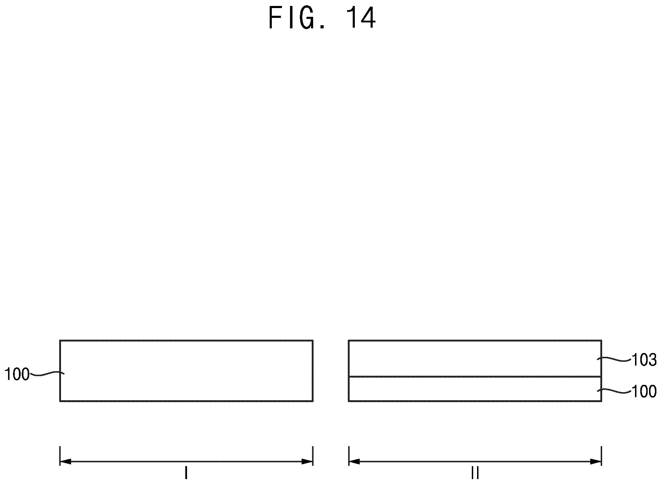

FIG. 14 is a cross-sectional view illustrating a method of forming a semiconductor device in accordance with example embodiments. This method may include processes substantially the same as or similar to those illustrated with reference to FIGS. 1 to 12, and thus repeated explanations thereof are omitted herein.

Referring to FIG. 14, an upper portion of the second region II of the substrate 100 may planarized by, for example, a grinding process, or, for example, a chemical mechanical polishing (CMP) process, an etch back process, etc.

Accordingly, in reference to the lower surface of the substrate 100, the height of the upper surface in the second region II of the substrate 100 may be formed to be lower than the height of the upper surface in the first region I of the substrate 100.

Thereafter, manufacturing of the semiconductor device may be completed by performing processes the same as or similar to the processes illustrated with reference to FIGS. 3 to 12 and FIGS. 1 to 2.

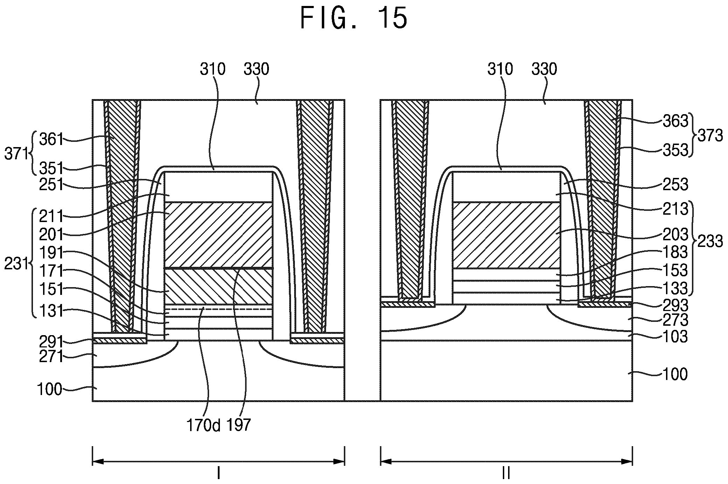

FIG. 15 is a cross-sectional view illustrating a semiconductor device in accordance with example embodiments. The semiconductor device may be the same as or similar to a semiconductor device of FIGS. 1 and 2, except for the third gate dielectric pattern 171 further including a doped region 171d, and thus repeated explanations are omitted herein.

Referring to FIG. 15, an upper portion of the third gate dielectric pattern 171 may be referred to a doped region 171d that may further contain a first impurity. In example embodiments, the first impurity may include carbon (C).

A negative charge may be formed at a portion of the first gate electrode 191 adjacent to a fourth interface of the doped region 171d of the third gate dielectric pattern 171 and the first gate electrode 191, and a positive charge may be formed at a portion of the doped region 171d of the third gate dielectric pattern 171 adjacent to the fourth interface. For example, a dipole may be formed at a vicinity of the fourth interface of the third gate dielectric pattern 171 and the first gate electrode 191. As a dipole is additionally induced at the vicinity of the fourth interface, the effective work function of the first gate electrode 191 may be further reduced, and accordingly, the first transistor may have an appropriate threshold voltage value.

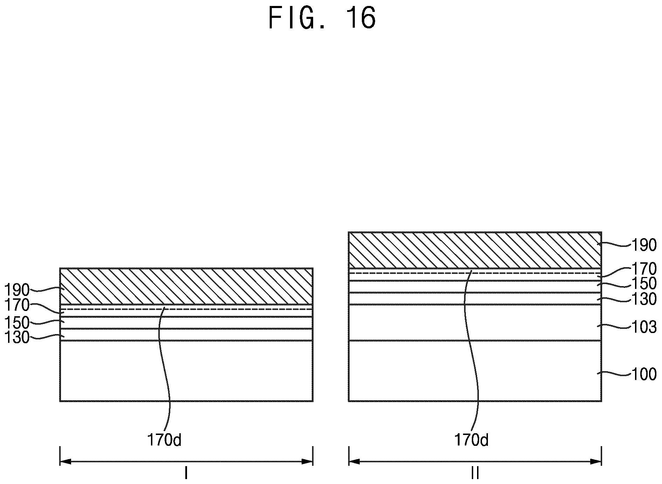

FIG. 16 is a cross-sectional view illustrating a method of forming a semiconductor device in accordance with example embodiments. This method may include processes substantially the same as or similar to those illustrated with reference to FIGS. 1 to 12, and thus repeated explanations thereof are omitted herein.

Referring to FIG. 16, processes substantially the same as or similar to those illustrated with reference to FIGS. 3 and 4 may be performed. However, a doped region 170d may be formed at an upper portion of the second gate dielectric layer 170 by performing an ion implantation process using a first impurity. In example embodiments, the first impurity may include carbon (C).

Thereafter, manufacturing of the semiconductor device may be completed by performing processes substantially the same as or similar to the processes illustrated with reference to FIGS. 5 to 12 and FIGS. 1 to 2.

While the present inventive concepts have been shown and described with reference to example embodiments thereof, it will be understood by those of ordinary skill in the art that various changes in form and details may be made thereto without departing from the spirit and scope of the present inventive concepts as set forth by the following claims.

## Claims

1. A semiconductor device comprising:
a first transistor including:
a first gate structure including a first gate interface pattern, a first gate dielectric pattern, a second gate dielectric pattern and a first gate electrode structure sequentially stacked on a first region of a substrate including the first region and a second region, wherein the first gate dielectric pattern contains a compound of a first metal, wherein a dielectric constant of the compound of the first metal is greater than a dielectric constant of silicon oxide, and wherein the second gate dielectric pattern contains an oxide of a second metal or an oxynitride of the second metal, the second metal being different from the first metal; and
a first source/drain region at an upper portion of the substrate that is adjacent to the first gate structure and contains n-type impurities; and
a second transistor including:
a second gate structure including a second gate interface pattern, a third gate dielectric pattern, a fourth gate dielectric pattern and a second gate electrode sequentially stacked on the second region of the substrate, wherein the third gate dielectric pattern includes the compound of the first metal, wherein the fourth gate dielectric pattern contains an oxide of a third metal or an oxynitride of the third metal, the third metal being different from the first metal; and
a second source/drain region at a second upper portion of the substrate that is adjacent to the second gate structure and contains p-type impurities,
wherein an oxygen areal density of the oxide of the second metal is smaller than an oxygen areal density of silicon oxide, and an oxide areal density of the oxide of the third metal is greater than the oxygen areal density of silicon oxide.

2. The semiconductor device of claim 1, wherein the second metal includes lanthanum, scandium, or a combination thereof, and the third metal includes aluminum, zirconium, titanium, or a combination thereof.

3. The semiconductor device of claim 1, wherein the first gate dielectric pattern further contains the oxide of the second metal, and the third gate dielectric pattern further contains the oxide of the third metal.

4. The semiconductor device of claim 1, wherein a thickness of the first gate electrode structure in a vertical direction substantially perpendicular to an upper surface of the substrate is greater than a thickness of the second gate electrode in the vertical direction.

5. The semiconductor device of claim 1, further comprising an epitaxial layer containing germanium or silicon-germanium at an upper portion of the second region of the substrate.

6. The semiconductor device of claim 1, wherein an upper portion of the second gate dielectric pattern contains carbon.

7. A semiconductor device comprising:
a first transistor including:
a first gate structure including a first gate interface pattern, a first gate dielectric pattern, a second gate dielectric pattern and a first gate electrode structure sequentially stacked on a first region of a substrate including the first region and a second region, wherein the second gate dielectric pattern contains an oxide of a first metal or an oxynitride of the first metal; and
a first source/drain region at an upper portion of the substrate that is adjacent to the first gate structure; and
a second transistor including:
a second gate structure including a second gate interface pattern, a third gate dielectric pattern, a fourth gate dielectric pattern and a second gate electrode sequentially stacked on the second region of the substrate, wherein the fourth gate dielectric pattern contains an oxide of a second metal or an oxynitride of the second metal, the second metal being different from the first metal; and
a second source/drain region at a second upper portion of the substrate that is adjacent to the second gate structure,
wherein a positive charge is formed at a portion of the first gate interface pattern adjacent to a first interface of the first gate interface pattern and the first gate dielectric pattern, and a negative charge is formed at a portion of the first gate dielectric pattern adjacent to the first interface, thereby forming a dipole at a vicinity of the first interface, and
wherein a second negative charge is formed at a portion of the second gate interface pattern adjacent to a second interface of the second gate interface pattern and the third gate dielectric pattern, and a second positive charge is formed at a portion of the third gate dielectric pattern adjacent to the second interface, thereby forming a second dipole at a vicinity of the second interface.

8. The semiconductor device of claim 7, wherein the first transistor is an NMOS transistor, and the second transistor is a PMOS transistor.

9. The semiconductor device of claim 7, wherein the first metal includes lanthanum, scandium, or a combination thereof, and the second metal includes aluminum, zirconium, titanium, or a combination thereof.

10. The semiconductor device of claim 7, wherein each of the first and third gate dielectric patterns includes a compound of a third metal having a higher dielectric constant than silicon oxide.

11. The semiconductor device of claim 10, wherein the first gate dielectric pattern further contains the oxide of the first metal, and the third gate dielectric pattern further contains the oxide of the second metal.

12. The semiconductor device of claim 7, wherein a thickness of the first gate electrode structure in a vertical direction substantially perpendicular to an upper surface of the substrate is greater than a thickness of the second gate electrode in the vertical direction.

13. The semiconductor device of claim 7, wherein an upper portion of the second gate dielectric pattern contains carbon.

14. A semiconductor device comprising:
a first transistor including:
a first gate structure including a first gate interface pattern, a first gate dielectric pattern and a first gate electrode structure sequentially stacked on a NMOS region of a substrate including the NMOS region and a PMOS region, wherein the first gate dielectric pattern contains an oxide of a first metal or an oxynitride of the first metal, and wherein the first gate structure has a first gate electrode and a second gate electrode sequentially stacked; and
a first source/drain region at an upper portion of the substrate that is adjacent to the first gate structure; and
an epitaxial layer on the PMOS region of the substrate; and
a second transistor including:
a second gate structure including a second gate interface pattern, a second gate dielectric pattern and a third gate electrode sequentially stacked on the epitaxial layer, wherein the second gate dielectric pattern contains an oxide of a second metal or an oxynitride of the second metal, the second metal being different from the first metal; and
a second source/drain region at an upper portion of the epitaxial layer adjacent to the second gate structure,
wherein an interface oxide layer is disposed between the first gate electrode and the second gate electrode.

15. The semiconductor device of claim 14, wherein an upper surface of the epitaxial layer is higher than an upper surface of the NMOS region of the substrate.
